# EUROPEAN PATENT APPLICATION

(11) **EP 4 443 722 A1**
(43) Date of publication of application: **09.10.2024**
(21) Application number: 21956278.2
(22) Date of filing: 07.09.2021
(51) Int. Cl.: H02M 1/00, H02M 5/00, H02M 7/00

(54) **SWITCHING CELL FOR POWER CONVERTERS**

(71) Applicant: Universidad Técnica Federico Santa María, Valparaiso (CL)
(72) Inventor: RENAUDINEAU, Hugues Jean-Marie, Valparaíso (CL); KOURO RENAER, Samir Felipe, Viña del Mar (CL); ROJAS MONRROY, Christian Alexis, Valparaíso (CL)
(74) Representative: Barbaro, Gaetano
(86) International application number: PCT/CL2021/050080
(87) International publication number: WO 2023/035087

(57) **Abstract**

The present invention relates to the field of electronics, specifically to the field of apparatus for converting an AC or DC input into an AC or DC output and in particular provides a switching cell for a power converter device characterized in that it comprises: a first switch, second switch, third switch and fourth switch connected in series one after the other; a fifth switch connected to the point between the second switch and the third switch; a sixth switch connected in series with said fifth switch and with a reference point; a first AC link connected to the point between the first switch and the second switch and to the point between the fifth switch and the sixth switch; and a second AC link connected to the point between the third switch and the fourth switch and to the point between the fifth switch and the sixth switch. The present invention further provides a power converter device comprising such a switching cell.

## Description

### TECHNICAL FIELD OF THE INVENTION

The present invention relates to the field of electronics, specifically with the field of apparatus for converting an AC or DC input into an AC or DC output and in particular provides a switching cell for a power converter device and a power converter device comprising said switching cell.

### BACKGROUND OF THE INVENTION

An important part of the configuration of power converters are the internal switching cells.

A number of switching cells configurations are known in the state of the art, but as the technology matures, new switching cells requirements arise.

Among the solutions described in the state of the art are, for example, what is proposed in document WO2020035527, which describes a power converter that receives a three-phase AC input and delivers a DC output. Each input phase has a capacitor that functions as an input filter, so that they are arranged in a star configuration. The centre point of the star is, in turn, connected to the input neutral and to the centre point of a power output stage featuring two switches in series. In addition, each phase is connected to a corresponding branch of a bridge rectifier, which is formed by two switches in series. To follow the assembly formed by two of the capacitors, their corresponding rectifier bridge branches and the power output stage, a configuration similar to that of the switching cell of the present invention is observed, but which differs in that, by making the ratio 1 to 1, the voltage input would be short-circuited to the output and, in addition, the sixth switch would be connected to the voltage output and not to the reference point.

An important part of the configuration of power converters are the internal switching cells. It is generally recognised that the different switching states of these switching cells, as well as the switching sequence, determine the output signal of the power converter.

Some configurations of switching cells are known in the state of the art, but as the technology matures, new requirements for switching cells emerge, e.g. to provide higher switching frequencies or to operate at higher powers.

As a consequence, there is a need for a topology for a switching to meet these requirements.

### SUMMARY OF THE INVENTION

The present invention provides a switching cell for a power converter device which is characterized in that it comprises: a first switch, second switch, third switch and fourth switch connected in series one after the other; a fifth switch connected to the point between the second switch and the third switch; a sixth switch connected in series with the said fifth switch and with a reference point; a first AC link connected to the point between the first switch and the second switch and to the point between the fifth switch and the sixth switch; and a second AC link connected to the point between the third switch and the fourth switch and to the point between the fifth switch and the sixth switch.

In a preferred embodiment, the switching cell is characterized in that it additionally comprises a third AC link connected to the point between the first switch the second switch and to the point between the third switch and the fourth switch. In a more preferred embodiment, the switching cell is characterized in that said first AC link, said second AC link and said third AC link have corresponding midpoints and that the switching cell additionally comprises a fourth three-phase AC link, wherein each phase of the said fourth AC link is connected to one of the said corresponding midpoints of the said first AC link, second AC link and third AC link.

In another preferred embodiment, the switching cell is characterized in that said first AC link and said second AC link exhibit corresponding midpoints and because the switching cell additionally comprises a third AC link that connects to said midpoints of said first AC link and said second AC link.

In a further preferred embodiment, the switching cell is characterized in that said first AC link and said second AC link are polyphase links and because, for each phase, said switching cell has corresponding first switch, second switch, third switch, fourth switch, fifth switch and sixth switch, wherein:
- each corresponding first switch is connected in series with its corresponding second switch;
- each corresponding third switch is connected in series with its corresponding fourth switch;
- each corresponding fifth switch is connected in series with its corresponding sixth switch;
- all the assemblies consisting of the corresponding first switch and second switch are connected in parallel to each other;
- all assemblies consisting of the corresponding third and fourth switches are connected in parallel to each other; and
- all assemblies consisting of the corresponding fifth and sixth switches are connected in parallel to each other;
- wherein the corresponding phase of the first AC link is connected to the point between the corresponding first switch and the corresponding second switch and to the point between the corresponding fifth switch and the corresponding sixth switch; and
- wherein the corresponding phase of the second AC link is connected to the point between the corresponding third switch and the corresponding fourth switch and to the point between the corresponding fifth switch and the corresponding sixth switch.

In a more preferred embodiment, the switching cell is characterized in that it comprises a third polyphase AC link, wherein each phase of said third AC link is connected to the point between the corresponding first switch and the corresponding second switch and to the point between the corresponding third switch and the corresponding fourth switch. In a still more preferred embodiment, the switching cell is characterized in that each phase of said first AC link, each phase of said second AC link and each phase of said third AC link have corresponding midpoints and because the switching cell additionally comprises a fourth polyphase AC link, wherein said fourth polyphase AC link has three phases in each of said first AC link, second AC link and third AC link and because each phase of said fourth polyphase AC link is connected to one of said corresponding midpoints of said first AC link, second AC link and third AC link.

In another more preferred embodiment, the switching cell is characterized in that each phase of said first AC link and each phase of said second AC link have corresponding midpoints and because the switching cell additionally comprises a third polyphase AC link, where each phase of said third AC link is connected to a corresponding midpoint of said first AC link and said second AC link.

In a preferred embodiment, the switching cell is characterized in that said switches are chosen from the group consisting of diodes, IGBT transistors, MOSFET transistors, as well as a combination thereof.

In another preferred embodiment, the switching cell is characterized in that said first AC link and second AC link are selected from the group consisting of capacitors, coils, transformers, as well as a combination thereof.

The present invention further provides a device for power conversion characterized in that it includes a switching cell comprising: a first switch, a second switch, a third switch, and a fourth switch connected in series one after the other; a fifth switch connected to the point between the second and third switch; a sixth switch connected in series with the said fifth switch and a reference point; a first AC link connected to the point between the first switch and the third switch and to the point between the fifth switch and the sixth switch; a second AC link connected to the point between the third switch and the fourth switch and to the point between the fifth switch and the sixth switch.

In a preferred embodiment, the device is characterized in that the switching cell additionally comprises a third AC link connected to the point between the first switch and the second switch and to the point between the third switch and the fourth switch. In a more preferred embodiment, the device is characterized in that said first AC link, said second AC link and said third AC link have corresponding midpoints and that the switching cell additionally comprises a fourth three-phase AC link, wherein each phase of said fourth AC link is connected to one of said corresponding midpoints of said first AC link, second AC link and third AC link.

In another preferred embodiment, the device is characterized in that the said first AC link and said second AC link have corresponding midpoints and because the switching cell additionally comprises a third AC link which is connected to said midpoints of said first AC link and said second AC link.

In a further preferred embodiment, the device is characterized in that the following features said first AC link and said second AC link are polyphase links and in that, for each phase, said switching cell has corresponding first switch, second switch, third switch, fourth switch, fifth switch and sixth switch, wherein:
- each corresponding first switch is connected in series with its corresponding second switch;
- each corresponding third switch is connected in series with its corresponding fourth switch;
- each corresponding fifth switch is connected in series with its corresponding sixth switch;
- all assemblies consisting of the corresponding first switch and second switch are connected in parallel to each other;
- all assemblies consisting of the corresponding third switch and fourth switch are connected in parallel to each other; and
- all assemblies consisting of the corresponding fifth switch and sixth switch are connected in parallel to each other;
- wherein the corresponding phase of the first AC link connects to the point between the corresponding first switch and the corresponding second switch and to the point between the corresponding fifth switch and the corresponding sixth switch; and
- wherein the corresponding phase of the second AC link is connected to the point between the corresponding third switch and the corresponding fourth switch and to the point between the corresponding fifth switch and the corresponding sixth switch.

In a more preferred embodiment, the device is characterized in that the switching cell comprises a polyphase third AC link, wherein each corresponding phase of said third AC link is connected to the point between the corresponding first switch and the corresponding second switch and to the point between the corresponding third switch and the corresponding fourth switch. In a still more preferred embodiment, the device is characterized in that each phase of said first AC link, each phase of said second AC link and each phase of said third AC link have corresponding midpoints and because the switching cell additionally comprises a fourth polyphase AC link, wherein said fourth polyphase AC link has three phases in each of said first AC link, second AC link and third AC link and because each phase of said fourth polyphase AC link is connected to one of said corresponding midpoints of said first AC link, second AC link and third AC link.

In another more preferred embodiment, the device is characterized in that each phase of said first AC link and each phase of said second AC link have corresponding midpoints and that the switching cell additionally comprises a third polyphase AC link, wherein each phase of said third AC link is connected to a corresponding midpoint of said first AC link and said second AC link.

In a preferred embodiment, the device is characterized in that said switches are chosen from the group consisting of diodes, IGBT transistors, MOSFET transistors, as well as a combination thereof.

In another preferred embodiment, the device is characterized in that said first AC link and second AC link are selected from the group consisting of capacitors, coils, transformers, as well as a combination thereof.

### BRIEF DESCRIPTION OF THE FIGURES

FIG. 1 illustrates a schematic diagram of a first embodiment of the switching cell which is the subject of the present invention.
FIG. 2 illustrates a schematic diagram of a second embodiment of the switching cell which is the subject of the present invention.
FIG. 3 illustrates a schematic diagram of a third embodiment of the switching cell which is the subject of the present invention.
FIG. 4 illustrates a schematic diagram of a fourth embodiment of the switching cell which is the subject of the present invention.
FIG. 5 illustrates a schematic diagram of a fifth embodiment of the switching cell which is the subject of the present invention.
FIG. 6 illustrates a schematic diagram of a sixth embodiment of the switching cell which is the subject of the present invention.
FIG. 7 illustrates a schematic diagram of a seventh embodiment of the switching cell which is the subject of the present invention.
FIG. 8 illustrates a schematic diagram of an eighth embodiment of the switching cell which is the subject of the present invention.
FIG. 9 illustrates a schematic diagram of an application of a first embodiment of the device for power conversion which is the subject of the present invention.
FIG. 10 illustrates a schematic diagram of an application of a second embodiment of the device for power conversion which is the subject of the present invention.
FIG. 11 illustrates a schematic diagram of an application of a third embodiment of the device for power conversion which is the subject of the present invention.
FIG. 12 illustrates a schematic diagram of an application of a fourth embodiment of the device for power conversion which is the subject of the present invention.
FIG. 13 illustrates a schematic diagram of an application of a fifth embodiment of the device for power conversion which is the subject of the present invention.

### DETAILED DESCRIPTION OF THE INVENTION

The present invention will be described in detail below, with reference to the figures accompanying this application.

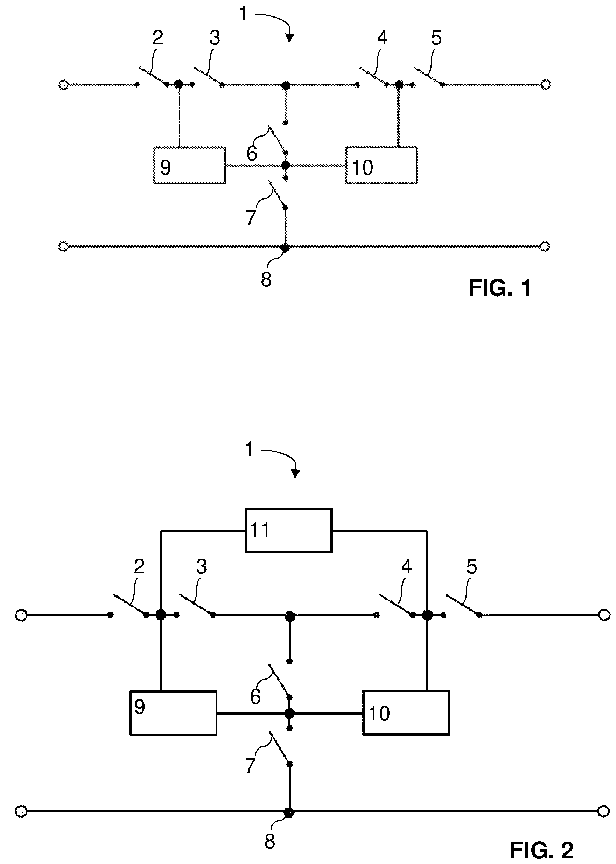

In a first object of the present invention, as illustrated schematically in FIGs. 1 to 8, there is provided a switching cell (1) for a device for power conversion comprising, substantially:
- a first switch (2), second switch (3), third switch (4) and fourth switch (5) connected in series one after the other;
- a fifth switch (6) connected to the point between the second switch (3) and the third switch (4);
- a sixth switch (7) connected in series with said fifth switch (6) and a reference point (8);
- a first AC link (9) connected to the point between the first switch (2) and the second switch (3) and to the point between the fifth switch (6) and the sixth switch (7); and
- a second AC link (10) connected to the point between the third switch (4) and the fourth switch (5) and to the point between the fifth switch (6) and the sixth switch (7).

In the context of the present invention, without this limiting the scope of the same, switch shall be understood as one or more elements that can selectively connect two or more terminals. The particular topology in which such a switch is manufactured does not limit the scope of the present invention. A person skilled in the art will understand that, in a preferred embodiment, such a switch can be manufactured from electronic components which can be selected from the group consisting of diodes, IGBT transistors, MOSFET transistors, as well as a combination thereof.

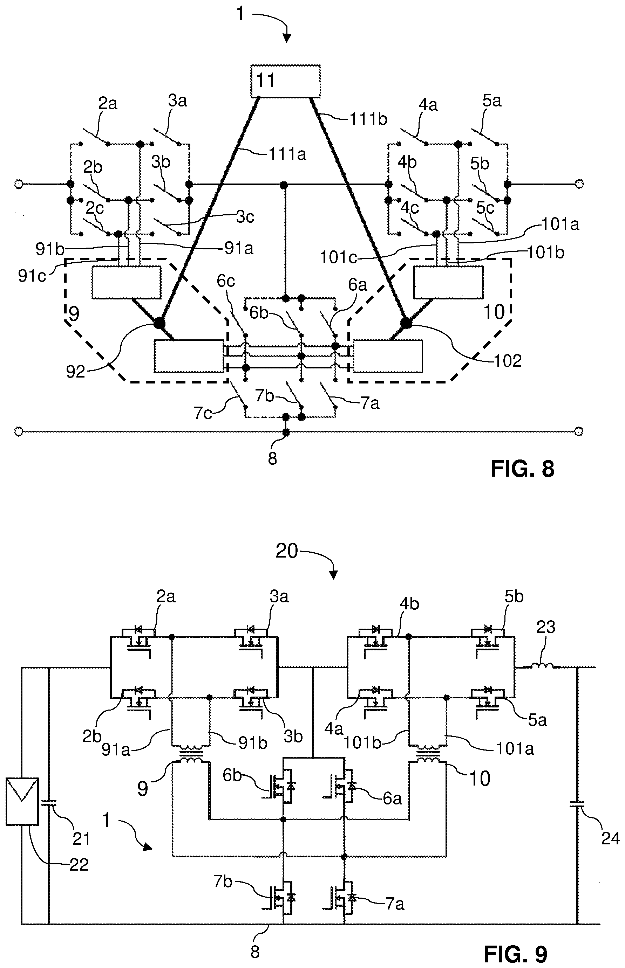

Such a switch may be a unidirectional or bidirectional switch without limiting the scope of the present invention. For example, and without limiting the scope of the present invention in FIGs. 9 to 13 illustrate switches consisting of a MOSFET transistor and a rectifier diode connected to the source and sink of said MOSFET transistor. However, in other embodiments, without limiting the scope of the present invention, it is possible to obtain a switch by connecting a rectifier diode to the emitter and collector of an IGBT transistor. A third example of an implementation of a unidirectional switch can be provided by a rectifier diode connected in series with the switch of the above example. On the other hand, without limiting the scope of the present invention, such a switch may be a bidirectional switch. Such a configuration may be obtained, for example and without limiting the scope of the present invention, by connecting in series two unidirectional switches, where such unidirectional switches have opposite switching directions to each other. For example, you can have switches based on IGBT transistors where the emitter is common, as well as switches based on IGBT transistors where the collector is common. Another example of realisation, without limiting the scope of the present invention, is obtained by connecting four diodes in a bridge rectifier configuration and connecting the emitter and collector of an IGBT transistor to the DC terminals of said bridge rectifier. A third example of realisation, without limiting the scope of the present invention, can be obtained when said switch is an RB-IGBT switch (from the English Reverse Blocking IGBT).

Each such first switch (2), second switch (3), third switch (4), fourth switch (5), fifth switch (6) or sixth switch (7) may be manufactured according to any of the previously described options, or others known to a person skilled in the art, without limiting the scope of the present invention.

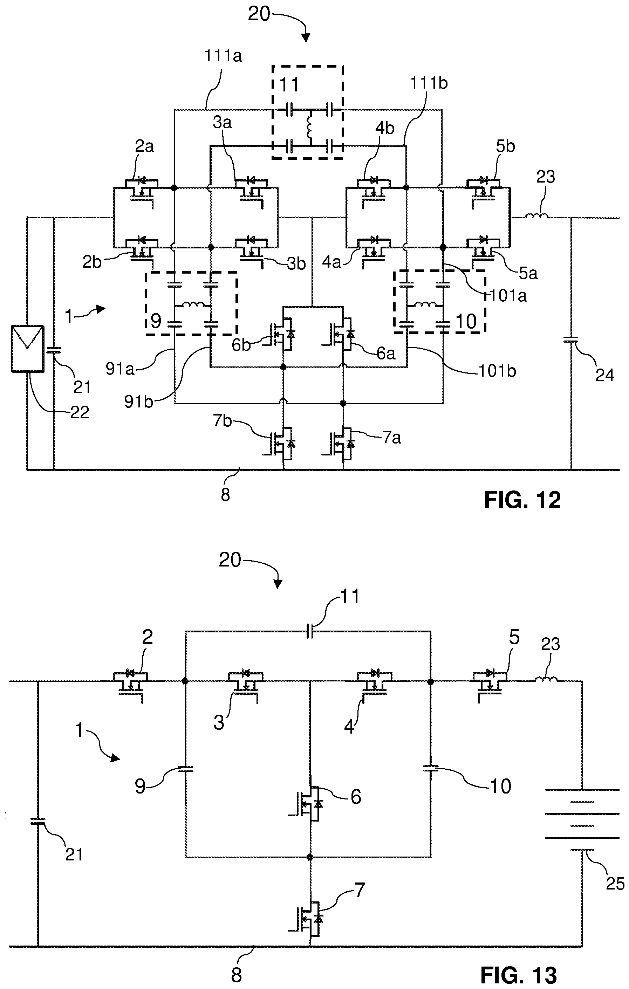

In addition, said first switch (2), second switch (3), third switch (4), fourth switch (5), fifth switch (6) and sixth switch (7) may or may not present the same configuration without limiting the scope of the present invention. In a preferred embodiment, without limiting the scope of the present invention and as illustrated schematically in FIG. 13, said first switch (2), second switch (3), third switch (4), fourth switch (5), fifth switch (6) and sixth switch (7) are unidirectional switches obtained by connecting a rectifier diode to the source and sink of a MOSFET transistor.

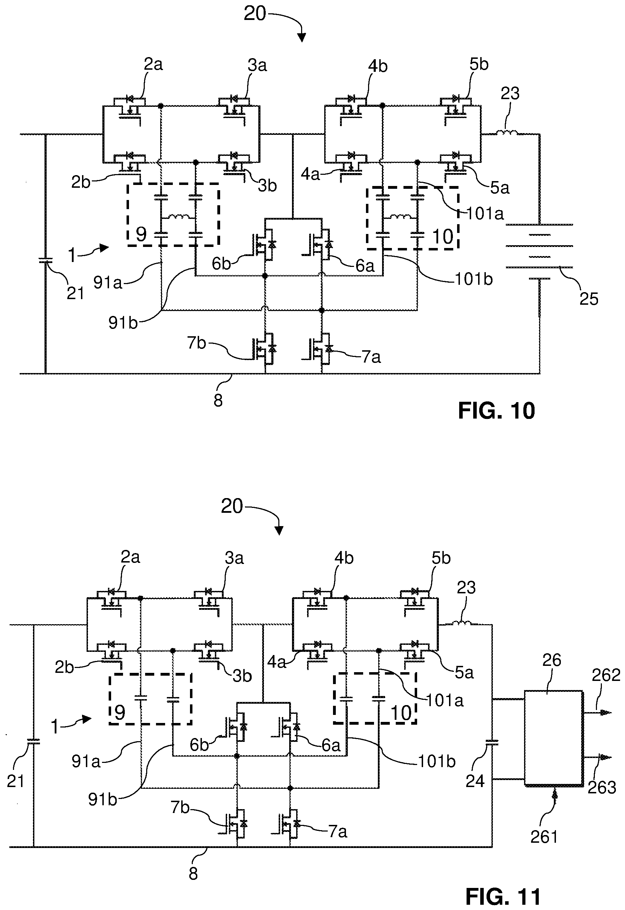

In the context of the present invention, without limiting the scope of the present invention, an AC link shall be understood as one or more elements allowing the connection of an AC bus to the switching cell (1) which is the subject of the present invention. Said AC link may be of an inductive or capacitive nature, as well as a combination thereof, without limiting the scope of the present invention. For example, and without limiting the scope of the present invention, said AC link may be selected from the group consisting of capacitors, coils and transformers, as well as a combination thereof. Said AC link may be single-phase or polyphase without limiting the scope of the present invention. For example, and without limiting the scope of the present invention, FIG. 13 illustrates single-phase AC links (9, 10) formed by two capacitors. In turn, without limiting the scope of the present invention, FIG. 11 illustrates polyphase AC links (9, 10) where each phase is formed by a corresponding capacitor, while FIG. 9 illustrates AC links (9, 10) formed by two transformers and FIGs. 10 and 12 illustrate AC links (9, 10, 11) formed by four capacitors and one coil arranged in an H-bridge configuration. In another example not shown in the figures, and without limiting the scope of the present invention, it is possible to obtain three-phase AC links by arranging three capacitors or three coils in a delta or star configuration, or a combination of both.

Each of said first AC link (9) and second AC link (10) can be manufactured according to any of the previously described configurations, as well as others known to a person skilled in the art, without limiting the scope of the present invention. Additionally, said first AC link (9) and second AC link (10) may or may not have the same configuration without limiting the scope of the present invention.

FIG. 1 illustrates a first embodiment of the switching cell (1) which is the subject of the present invention. In such a first embodiment, without limiting the scope of the present invention, the first AC link (9) and the second AC link (10) are single-phase AC links. Furthermore, in this figure, the first switch (2), second switch (3), third switch (4), fourth switch (5), fifth switch (6) and sixth switch (7) are described generically.

FIG. 2 illustrates a second embodiment of the switching cell (1) that is the subject of the present invention. In this preferred embodiment, in addition to the first AC link (9) and the second AC link (10) a third AC link (11) is provided which is connected to the point between the first switch (2) and the second switch (3) and to the point between the third switch (4) and the fourth switch (5). Said third AC link (11) may be manufactured according to any of the following alternatives previously described for the first AC link (9) or for the second AC link (10), as well as with others known to a person normally skilled in the art, without this limiting the scope of the present invention. In this preferred embodiment, furthermore, said first AC link (9), second AC link (10) and third AC link (11) may or may not possess the same configuration without limiting the scope of the present invention.

In this preferred embodiment, in addition, and without limiting the scope of the present invention, said first AC link (9), second AC link (10) and third AC link (11) are single-phase AC links.

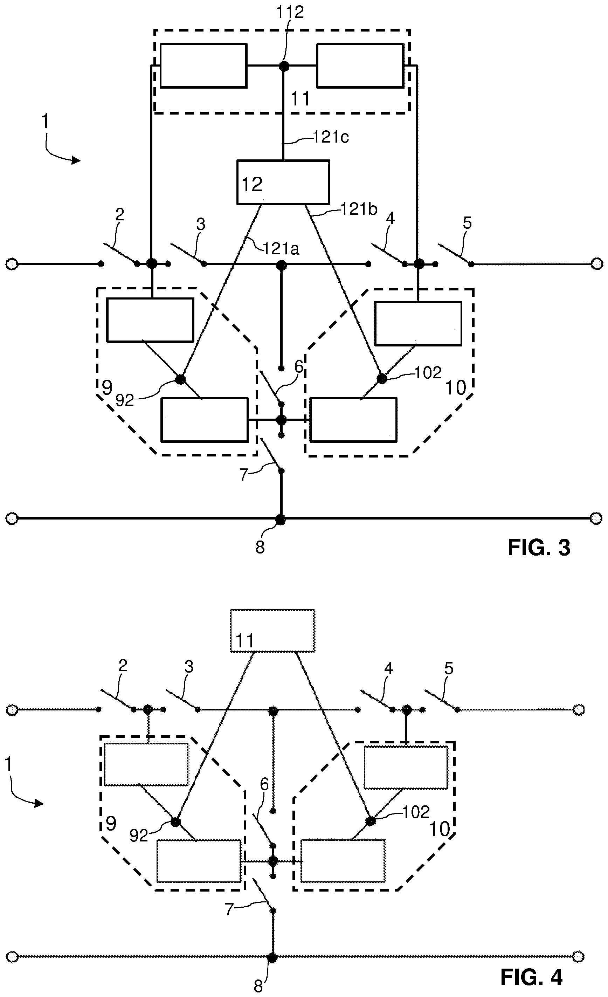

FIG. 3 illustrates a third preferred embodiment of the switching cell (1) which is the subject of the present invention. In this preferred embodiment, the switching cell (1) comprises a first AC link (9) and a second AC link (10) and further comprises a third AC link (11) that connects to the point between the first switch (2) and the second switch (3) and to the point between the third switch (4) and the fourth switch (5). Said third AC link (11) may be manufactured according to any of the previously described alternatives for the first AC link (9) or for the second AC link (10), as well as other known to a person ordinarily skilled in the art, without this limiting the scope of the present invention. In this preferred embodiment, furthermore, said first AC link (9), second AC link (10) and third AC link (11) may or may not possess the same configuration without this limiting the scope of the present invention.

In this preferred embodiment, without limiting the scope of the present invention, said first AC link (9), said second AC link (10) and said third AC link (11) present corresponding midpoints (92, 102, 112). Furthermore, in this preferred embodiment and without limiting the scope of the present invention, said switching cell (1) features a fourth three-phase AC link (12). Each phase (121a, 121b, 121c) of said fourth three-phase AC link (12) is connected to one of said corresponding midpoints (92, 102, 112) of said first AC link (9), second AC link (10) and third AC link (11).

Any alternative known to a person normally skilled in the art can be used to fabricate such AC link with midpoint. Additionally, said first AC link (9), second AC link (10) and third AC link (11) may or may not possess the same configuration without this limiting the scope of the present invention. On the other hand, said fourth three-phase AC link (12) can be manufactured according to any of the previously described alternatives for three-phase AC links, as well as according to other alternatives known to a person skilled in the art, without limiting the scope of the present invention.

FIG. 4 illustrates a fourth preferred embodiment of the switching cell (1) which is the subject of the present invention. In this preferred embodiment, the switching cell (1) comprises a first AC link (9) and a second AC link (10), wherein said first AC link (9) and second AC link (10) have corresponding midpoints (92, 102). In this preferred embodiment, further and without limiting the scope of the present invention, the switching cell (1) comprises a third AC link (11) which is connected to said midpoints (92, 102) of the first AC link (9) and the second AC link (10).

Any alternative known to a person normally skilled in the art can be used to fabricate such AC link with midpoint. Additionally, said first AC link (9) and second AC link (10) may or may not possess the same configuration without this limiting the scope of the present invention. On the other hand, said third AC link (11) may be manufactured according to any of the alternatives previously described for the first AC link (9) or for the second AC link (10), as well as with others known to exist for a person ordinarily skilled in the art, without limiting the scope of the present invention.

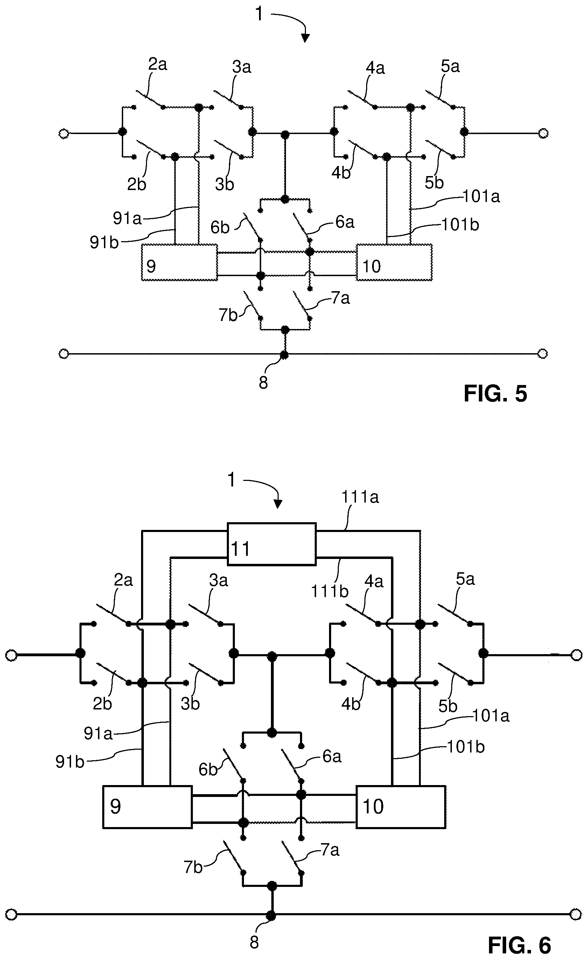

FIG. 5 illustrates a fifth preferred embodiment of the switching cell (1) which is the subject of the present invention. In this preferred embodiment, said first AC link (9) and second AC link (10) are polyphasic links. However, wherein said figure a switching cell (1) is illustrated in which said first AC link (9) and said second AC link (10) each present two phases, the number of phases presented by said first AC link (9) or said second AC link (10) does not limit the scope of the present invention. In this preferred embodiment, in addition and without this limiting the scope of the present invention, for each phase (91a, 91b, 101a, 101b), the switching cell (1) has corresponding first switch (2a, 2b), second switch (3a, 3b), third switch (4a, 4b), fourth switch (5a, 5b), fifth switch (6a, 6b) and sixth switch (7a, 7b).

In this preferred embodiment, in addition and without limiting the scope of the present invention, each corresponding first switch (2a; 2b) connects in series with its corresponding second switch (3a; 3b) and then, all the assemblies formed by the corresponding first switch and second switch (2a-3a; 2b-3b) are connected in parallel to each other. Similarly, without limiting the scope of the present invention, each corresponding third switch (4a; 4b) is connected in series with its corresponding fourth switch (5a; 5b) and then, all the assemblies formed by the corresponding third switch and fourth switch (4a-5a; 4b-5b) are connected in parallel to each other. Furthermore, without limiting the scope of the present invention, each corresponding fifth switch (6a; 6b) is connected in series with its corresponding sixth switch (7a; 7b) and then, all the assemblies formed by the corresponding fifth switch and sixth switch (6a-7a; 6b-7b) are connected in parallel to each other. In this way, a switching cell (1) is obtained in which each phase has its corresponding set of switches.

In this preferred embodiment, in addition, and without limiting the scope of the present invention, each corresponding phase (91a, 91b) of the first AC link (9) is connected to the point between its corresponding first switch (2a, 2b) and its corresponding second switch (3a, 3b) and to the point between its corresponding fifth switch (6a, 6b) and its corresponding sixth switch (7a, 7b). Similarly, and without limiting the scope of the present invention, each corresponding phase (101a, 101b) of the second AC link (10) is connected to the point between its corresponding third switch (4a, 4b) and its corresponding fourth switch (5a, 5b) and to the point between its corresponding fifth switch (6a, 6b) and its corresponding sixth switch (7a, 7b).

FIG. 6 illustrates a sixth preferred embodiment of the switching cell (1) which is the subject of the present invention. In this preferred embodiment, said first AC link (9) and second AC link (10) are polyphase links. Although said figure illustrates a switching cell (1) in which said first AC link (9) and second AC link (10) each have two phases, the number of phases present in said first AC link (9) or said second AC link (10) does not limit the scope of the present invention. In this preferred embodiment, in addition and without this limiting the scope of the present invention, for each phase (91a, 91b, 101a, 101b), the switching cell (1) has corresponding first switch (2a, 2b), second switch (3a, 3b), third switch (4a, 4b), fourth switch (5a, 5b), fifth switch (6a, 6b) and sixth switch (7a, 7b).

In this preferred embodiment, in addition, and without limiting the scope of the present invention, each corresponding first switch (2a; 2b) is connected in series with its corresponding second switch (3a; 3b) and then, all the assemblies formed by the corresponding first switch and second switch (2a-3a; 2b-3b) are connected in parallel to each other. Similarly, without this limiting the scope of the present invention, each corresponding third switch (4a; 4b) is connected in series with its corresponding fourth switch (5a; 5b) and then, all the assemblies formed by the corresponding third switch and fourth switch (4a-5a; 4b-5b) are connected in parallel to each other. In addition, without limiting the scope of the present invention, each corresponding fifth switch (6a; 6b) is connected in series with its corresponding sixth switch (7a; 7b) and then, all the sets formed by the corresponding fifth switch and sixth switch (6a-7a; 6b-7b) are connected in parallel to each other. In this way, a switching cell (1) is obtained in which each phase has its corresponding set of switches.

In this preferred embodiment, in addition and without limiting the scope of the present invention, each corresponding phase (91a, 91b) of the first AC link (9) is connected to the point between its corresponding first switch (2a, 2b) and its corresponding second switch (3a, 3b) and to the point between its corresponding fifth switch (6a, 6b) and its corresponding sixth switch (7a, 7b). Similarly, and without limiting the scope of the present invention, each corresponding phase (101a, 101b) of the second AC link (10) is connected to the point between its corresponding third switch (4a, 4b) and its corresponding fourth switch (5a, 5b) and to the point between its corresponding fifth switch (6a, 6b) and its corresponding sixth switch (7a, 7b).

In this preferred embodiment, in addition and without limiting the scope of the present invention, the switching cell (1) further comprises, in addition, a third polyphase AC link (11). The number of phases present in said third AC link (11) does not limit the scope of the present invention and will depend, for example and without limiting the scope of the present invention, on the number of phases present in said first AC link (9) or said second AC link (10).

Each phase (111a, 111b) of said third polyphase AC link (11) is connected with the point between its corresponding first switch (2a, 2b) and its corresponding second switch (3a, 3b) and to the point between its corresponding third switch (4a, 4b) and its corresponding fourth switch (5a, 5b).

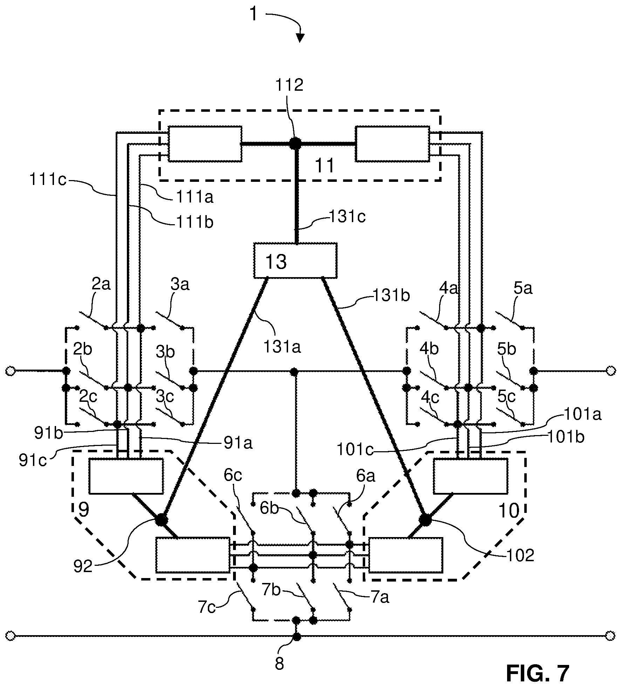

FIG. 7 illustrates a seventh preferred embodiment of the switching cell (1) which is the subject of the present invention. In this embodiment preferred, the switching cell (1) comprises a first AC link (9), a second AC link (10) and third AC link (11) which are connected in a manner similar to the preferred embodiment illustrated in FIG. 6. In this preferred embodiment, furthermore and without limiting the scope of the present invention, each phase (91a, 91b) of said first AC link (9), each phase (101a, 101b) of said second AC link (10) and each phase (111a, 111b) of said third AC link (11) have corresponding midpoints (92, 102, 112). Although in FIG. 7 a single midpoint is illustrated for each of said first AC link (9), second AC link (10) and third AC link (11), it is to be understood that such representation is made for the purpose of simplifying the presence of a midpoint for each phase of said AC links (9, 10, 11).

Wherein each of said phases is connected to a corresponding midpoint of said first AC link (9), said second AC link (10) or said third AC link (11). The preferred embodiment of the switching cell (1) illustrated in FIG. 7 further comprises a fourth polyphase AC link (13), which presents three phases in each of said first AC link (9), second AC link (10) and third AC link (11). That is to say, for example and without this limiting the scope of the present invention, that if said first AC link (9), said second AC link (10) and said third AC link (11) each have 3 phases, then said fourth polyphase AC link (13) has 9 phases. In this sense, it can be understood that said fourth polyphase AC link (13) corresponds to a "poly-three-phase" AC link. Although FIG. 7 illustrates a fourth polyphase AC link (13) from which three lines (131a, 131b, 131c) emerge, it is to be understood that each of said lines represents as many phases as exist in said first AC link (9), in said second AC link (10) or in said third AC link (11), respectively.

In this preferred embodiment, in addition, and without limiting the scope of the present invention, each phase (131a, 131b, 131c) of said fourth polyphase AC link (13) is connected with one of said corresponding midpoints (92, 102, 112) of said first AC link (9), second AC link (10) and third AC link (11).

FIG. 8 illustrates an eighth preferred embodiment of the switching cell (1) which is the subject of the present invention. In this preferred embodiment, the switching cell (1) comprises a first polyphase AC link (9) and a second polyphase AC link (10) which are connected in a manner similar to the preferred embodiment illustrated in FIG. 5.

Wherein each of these phases is connected to a corresponding midpoint of said first AC link (9), or said second AC link (10). In this preferred embodiment, in addition and without limiting the scope of the present invention, each phase (91a, 91b) of said first AC link (9) and each phase (101a, 101b) of said second AC link (10) have corresponding midpoints (92, 102). Although in FIG. 8 a single midpoint is illustrated for each of said first AC link (9) and second AC link (10), it should be understood that said representation is made for the purpose of simplifying the presence of a midpoint for each phase of said AC links (9, 10).

The preferred embodiment of the switching cell (1) illustrated in FIG. 8 further comprises a third, polyphase AC link (11), which features as many phases as each of said first AC link (9), second AC link (10). That is to say, for example and without this limiting the scope of the present invention, that if said first AC link (9) and said second AC link (10) present, each one, 3 phases, then said third AC link (11) will also present 3 phases. Although FIG. 8 shows a third AC link (11) from which two lines (111a, 111b) emerge, it should be understood that each of said lines represents as many phases as exist in said first AC link (9) or in said second AC link (10).

In this preferred embodiment, in addition and without limiting the scope of the present invention, each phase (111a, 111b) of said third AC link (11) is connected to one of said corresponding midpoints (92, 102) of said first AC link (9) and second AC link (10).

The present invention further provides a device (20) for power conversion, comprising a switching cell (1) comprising: a first switch (2), second switch (3), third switch (4) and fourth switch (5) connected in series one after the other; a fifth switch (6) connected to the point between the second switch (3) and the third switch (4); a sixth switch (7) connected in series with the said fifth switch (6) and with a reference point (8); a first AC link (9) connected to the point between the first switch (2) and the second switch (3) and to the point between the fifth switch (6) and the sixth switch (7); and a second AC link (9) connected to the point between the third switch (4) and the fourth switch (5), and to the point between the fifth switch (6) and the sixth switch (7).

All of the options previously described for the switching cell (1) as a separate object of invention are applicable to the switching cell (1) being part of the device (20) for power conversion.

According to the above detailed description, it is possible to obtain a switching cell (1) and a device (20) for power conversion to meet the requirements of the prior art.

It should be understood that the different options described for different technical characteristics can be combined with each other, or with other options known to a person normally skilled in the art, in any way, envisaged without limiting the scope of the present invention.

Examples of embodiments of the present invention will be described hereinafter. It should be understood that such examples are intended to provide a better understanding of the invention, but do not limit the scope of the invention.

In addition, the different options for technical features that are available in the described in different examples may be combined with each other, with other previously described options, or with other options known to a person skilled in the art, in any manner, provided that this does not limit the scope of the present invention.

### Example 1: Switching cell for photovoltaic applications

FIG. 9 illustrates a first application example of the switching cell (1) which is the subject of the present invention.

In this example, the first AC link (9) and the second AC link (10) are two-phase links formed by two transformers. In addition, each switch (2a, 2b, 3a, 3b, 4a, 4b, 5a, 5b, 6a, 6b, 7a, 7b) is a unidirectional switch consisting of a MOSFET transistor and a rectifier diode which is connected to the source and sink of the MOSFET transistor.

The power converter (20) further comprises an input capacitor (21) which is connected in parallel with the solar photovoltaic module (22), an output coil (23) which is connected in series with the switching cell (1) and an output capacitor (24) following said output coil (23) which is connected in parallel with the output of the power converter (20).

### Example 2: Switching cell for battery charging.

FIG. 10 illustrates a second example of application of the switching cell (1) which is the subject of the present invention.

In this example, the first AC link (9) and the second AC link (10) are two-phase links, each consisting of four capacitors and a coil in H-bridge configuration. In addition, each switch (2a, 2b, 3a, 3b, 4a, 4b, 5a, 5b, 6a, 6b, 7a, 7b) is a unidirectional switch consisting of a transistor MOSFET and a rectifier diode that is connected to the source and sink of the said MOSFET transistor.

The power converter (20) further comprises an input capacitor (21) which is connected in parallel with the power converter input (20) and an output coil (23) which is connected in series with the switching cell (1) and the battery (25).

### Example 3: Switching cell for an electrolyser.

FIG. 11 illustrates a third example of the application of the switching cell (1) which is the subject of the present invention.

In this example, the first AC link (9) and the second AC link (10) are two-phase links, each consisting of two capacitors. In addition, each switch (2a, 2b, 3a, 3b, 4a, 4b, 5a, 5b, 6a, 6b, 7a, 7b) is a unidirectional switch consisting of a MOSFET transistor and a rectifier diode that is connects to the source and sink of such a MOSFET transistor.

The power converter (20) further comprises an input capacitor (21) which is connected in parallel with the input of the power converter (20), an output coil (23) which is connected in series with the switching cell (1) and an output capacitor (24) which is connected in parallel with the electrolyser (26).

In this example embodiment, in addition, the electrolyser (26) has a water inlet (261), an oxygen outlet (262) and a hydrogen outlet (263).

### Example 4: Switching cell for photovoltaic applications

FIG. 12 illustrates a fourth example of the application of the switching cell (1) which is the subject of the present invention.

In this example, the first AC link (9) and the second AC link (10) are two-phase links, each consisting of four capacitors and a coil in H-bridge configuration. In addition, each switch (2a, 2b, 3a, 3b, 4a, 4b, 5a, 5b, 6a, 6b, 7a, 7b) is a unidirectional switch consisting of a transistor MOSFET and a rectifier diode that is connected to the source and sink of said MOSFET transistor. In this embodiment, in addition, the switching cell (1) comprises a third two-phase AC link (11) consisting of four capacitors and a coil in an H-bridge configuration, where each phase is connected the point between its corresponding first switch (2a, 2b) and its corresponding second switch (3a, 3b), and to the point between its corresponding third switch (4a, 4b) and its corresponding fourth switch (5a, 5b).

The power converter (20) further comprises an input capacitor (21) which is connected in parallel with the photovoltaic module (22), a coil output capacitor (23) which is connected in series with the switching cell (1) and an output capacitor (24) which is connected in parallel with the output of the power converter (20).

### Example 5: Switching cell for battery charging

FIG. 13 illustrates a fifth example of the application of the switching cell (1) which is the subject of the present invention.

In this example, the first AC link (9), the second AC link (10) and the third AC link (11) are single-phase links, each corresponding to a capacitor. In addition, each switch (2, 3, 4, 5, 6, 7) is a single-phase unidirectional switch consisting of a MOSFET transistor and a rectifier diode which is connected to the source and sink of the MOSFET transistor.

The power converter (20) further comprises an input capacitor (21) which is connected in parallel with the power converter input (20) and an output coil (23) which is connected in series with the switching cell (1) and with the battery (25).

## Claims

1. A switching cell (1) for a power converter device, **CHARACTERIZED in that** it comprises:
- a first switch (2), a second switch (3), a third switch (4) and a fourth switch (5) connected in series with each other;
- a fifth switch (6) connected to the point between the second switch (3) and the third switch (4);
- a sixth switch (7) connected in series with said fifth switch (6) and a reference point (8);
- a first AC link (9) connected to the point between the first switch (2) and the second switch (3) and to the point between the fifth switch (6) and the sixth switch (7); and
- a second AC link (10) connected to the point between the third switch (4) and the fourth switch (5) and to the point between the fifth switch (6) and the sixth switch (7).

2. The switching cell (1) of claim 1, **CHARACTERIZED in that** it further comprises a third AC link (11) connected to the point between the first switch (2) and the second switch (3) and to the point between the third switch (4) and the fourth switch (5).

3. The switching cell (1) of claim 1, **CHARACTERIZED in that** said first AC link (9), said second AC link (10) and said third AC link (11) have corresponding midpoints (92, 102, 112) and **in that** the switching cell (1) comprises, in addition, a fourth three-phase AC link (12), wherein each phase (121a, 121b, 121c) of said fourth AC link (12) is connected to one of said corresponding midpoints (92, 102, 112) of said first AC link (9), said second AC link (10) and said third AC link (11).

4. The switching cell (1) of claim 1, **CHARACTERIZED in that** said first AC link (9) and said second AC link (10) have corresponding midpoints (92, 102) and that the switching cell (1) additionally comprises a third AC link (11) which is connected to said midpoints (92, 102) of said first AC link (9) and said second AC link (10).

5. The switching cell (1) of claim 1, **CHARACTERIZED in that** said first AC link (9) and said second AC link (10) are polyphase links and that, for each phase (91a, 91b, 101a, 101b), said switching cell has corresponding a first switch (2a, 2b), a second switch (3a, 3b), a third switch (4a, 4b), a fourth switch (5a, 5b), a fifth switch (6a, 6b) and a sixth switch (7a, 7b), wherein:
- each corresponding first switch (2a; 2b) is connected in series with its corresponding second switch (3a; 3b);
- each corresponding third switch (4a; 4b) is connected in series with its corresponding fourth switch (5a; 5b);
- each corresponding fifth switch (6a; 6b) is connected in series with its corresponding sixth switch (7a; 7b);
- all assemblies consisting of the corresponding first switch and second switch (2a-3a; 2b-3b) are connected in parallel to each other;
- all assemblies consisting of the corresponding third switch and fourth switch (4a-5a; 4b-5b) are connected in parallel with each other; and
- all assemblies consisting of the corresponding fifth switch and sixth switch (6a-7a; 6b-7b) are connected in parallel with each other;
- wherein the corresponding phase (91a, 91b) of the first AC link is connected to the point between the corresponding first switch (2a, 2b) and the corresponding second switch (3a, 3b) and to the point between the corresponding fifth switch (6a, 6b) and the corresponding sixth switch (7a, 7b); and
- wherein the corresponding phase (101a, 101b) of the second AC link (10) is connected to the point between the corresponding third switch (4a, 4b) and the corresponding fourth switch (5a, 5b) and to the point between the corresponding fifth switch (6a, 6b) and the corresponding sixth switch (7a, 7b).

6. The switching cell (1) of claim 5, **CHARACTERIZED in that** it comprises a third polyphase AC link (11), wherein each corresponding phase (111a, 111b) of said third AC link (11) is connected to the point between the corresponding first switch (2a, 2b) and the corresponding second switch (3a, 3b) and to the point between the corresponding third switch (4a, 4b) and the corresponding fourth switch (5a, 5b).

7. The switching cell of claim 6, **CHARACTERIZED in that** each phase (91a, 91b) of said first AC link (9), each phase (101a, 101b) of said second AC link (10) and each phase (111a, 111b) of said third AC link (11) have corresponding midpoints (92, 102, 112) and because the switching cell (1) additionally comprises a fourth polyphase AC link (13), wherein said fourth polyphase AC link (13) has three phases in each of said first AC link (9), second AC link (10) and third AC link (11) and because each phase (131a, 131b, 131c) of said fourth polyphase AC link (13) is connected to one of said corresponding midpoints (92, 102, 112) of said first AC link (9), second AC link (10) and third AC link (11).

8. The switching cell (1) of claim 5, **CHARACTERIZED in that** each phase (91a, 91b) of said first AC link (9) and each phase (101a, 101b) of said second AC link (10) have corresponding midpoints (92, 102) and that the switching cell (1) additionally comprises a third, polyphase AC link (11), wherein each phase (111a, 111b) of said third AC link is connected to a corresponding midpoint (92, 102) of said first AC link (9) and said second AC link (10).

9. The switching cell (1) of claim 1, **CHARACTERIZED in that** said switches are selected from the group consisting of diodes, IGBT transistors, MOSFET transistors, as well as a combination thereof.

10. The switching cell (1) of claim 1, **CHARACTERIZED in that** said first AC link (9) and second AC link (10) are selected from the group consisting of capacitors, coils, transformers, as well as a combination thereof.

11. A device (20) for power conversion, **CHARACTERIZED in that** it includes a switching cell (1) comprising:
- a first switch (2), a second switch (3), a third switch (4) and a fourth switch (5) connected in series with one after the other;
- a fifth switch (6) connected to the point between the second switch (3) and the third switch (4);
- a sixth switch (7) connected in series with said fifth switch (6) and a reference point (8);
- a first AC link (9) connected to the point between the first switch (2) and the second switch (3) and to the point between the fifth switch (6) and the sixth switch (7); and
- a second AC link (10) connected to the point between the third switch (4) and the fourth switch (5) and to the point between the fifth switch (6) and the sixth switch (7).

12. The device (20) of claim 11, **CHARACTERIZED in that** the switching cell (1) additionally comprises a third AC link (11) connected to the point between the first switch (2) and the second switch (3) and to the point between the third switch (4) and the fourth switch (5).

13. The device (20) of claim 11, **CHARACTERIZED in that** said first AC link (9), said second AC link (10) and said third AC link (11) have corresponding midpoints (92, 102, 112) and **in that** the switching cell (1) additionally comprises, a fourth three-phase AC link (12), wherein each phase (121a, 121b, 121c) of said fourth AC link (12) is connected to one of said corresponding midpoints (92, 102, 112) of said first AC link (9), said second AC link (10) and said third AC link (11).

14. The device (20) of claim 11, **CHARACTERIZED in that** said first AC link (9) and said second AC link (10) have corresponding midpoints (92, 102) and **in that** the switching cell (1) additionally comprises a third AC link (11) which is connected to said midpoints (92, 102) of said first AC link (9) and said second AC link (10).

15. The device (20) of claim 11, **CHARACTERIZED in that** said first AC link (9) and said second AC link (10) are polyphase links and **in that**, for each phase (91a, 91b, 101a, 101b), said switching cell (1) has corresponding first switch (2a, 2b), second switch (3a, 3b), third switch (4a, 4b), fourth switch (5a, 5b), fifth switch (6a, 6b) and sixth switch (7a, 7b), wherein:
- each corresponding first switch (2a; 2b) is connected in series with its corresponding second switch (3a; 3b);
- each corresponding third switch (4a; 4b) is connected in series with its corresponding fourth switch (5a; 5b);
- each corresponding fifth switch (6a; 6b) is connected in series with its corresponding sixth switch (7a; 7b);
- all assemblies consisting of the corresponding first switch and second switch (2a-3a; 2b-3b) are connected in parallel to each other;
- all assemblies consisting of the corresponding third switch and fourth switch (4a-5a; 4b-5b) are connected in parallel with each other; and
- all assemblies consisting of the corresponding fifth switch and sixth switch (6a-7a; 6b-7b) are connected in parallel with each other;
- wherein the corresponding phase (91a, 91b) of the first AC link is connected to the point between the corresponding first switch (2a, 2b) and the corresponding second switch (3a, 3b) and to the point between the corresponding fifth switch (6a, 6b) and the corresponding sixth switch (7a, 7b); and
- wherein the corresponding phase (101a, 101b) of the second AC link (10) is connected to the point between the corresponding third switch (4a, 4b) and the corresponding fourth switch (5a, 5b) and to the point between the corresponding fifth switch (6a, 6b) and the corresponding sixth switch (7a, 7b).

16. The device (20) of claim 15, **CHARACTERIZED in that** the switching cell (1) comprises a third polyphase AC link (11), wherein each corresponding phase (111a, 111b) of said third AC link (11) is connected to the point between the corresponding first switch (2a, 2b) and the corresponding second switch (3a, 3b) and to the point between the corresponding third switch (4a, 4b) and the corresponding fourth switch (5a, 5b).

17. The device (20) of claim 16, **CHARACTERIZED in that** each phase (91a, 91b) of said first AC link (9), each phase (101a, 101b) of said second AC link (10) and each phase (111a, 111b) of said third AC link (11) have corresponding midpoints (92, 102, 112) and **in that** the switching cell (1) additionally comprises a fourth polyphase AC link (13), wherein said fourth polyphase AC link (13) has three phases in each of said first AC link (9), second AC link (10) and third AC link (11) and because each phase (131a, 131b, 131c) of said fourth polyphase AC link (13) is connected to one of said corresponding midpoints (92, 102, 112) of said first AC link (9), second AC link (10) and third AC link (11).

18. The device (20) of claim 15, **CHARACTERIZED in that** each phase (91a, 91b) of said first AC link (9) and each phase (101a, 101b) of said second AC link (10) have corresponding midpoints (92, 102) and **in that** the switching cell (1) comprises, in addition, a third polyphase AC link (11), wherein each phase (111a, 111b) of said third AC link is connected to a corresponding midpoint (92, 102) of said first AC link (9) and of said second AC link (10).

19. The device (20) of claim 11, **CHARACTERIZED in that** said switches are selected from the group consisting of diodes, IGBT transistors, MOSFET transistors, as well as a combination thereof.

20. The device (20) of claim 11, **CHARACTERIZED in that** said first AC link (9) and second AC link (10) are selected from the group consisting of capacitors, coils, transformers, as well as a combination thereof.
